Europäisches Patentamt

European Patent Office

Office européen des brevets

(19)

(11) Veröffentlichungsnummer: **0 304 396 B1**

## (12) EUROPÄISCHE PATENTSCHRIFT

(45) Veröffentlichungstag der Patentschrift:
09.10.91 Patentblatt 91/41

(51) Int. Cl.⁵: **B05D 1/26**, B05C 11/10, G01F 13/00

(21) Anmeldenummer: 88730186.9

(22) Anmeldetag: 17.08.88

(54) **Verfahren und Vorrichtung zum Dosieren und Auftragen von flüssigen oder pastösen Medien auf einen Gegenstand.**

(30) Priorität: 20.08.87 DE 3728054

(43) Veröffentlichungstag der Anmeldung:
22.02.89 Patentblatt 89/08

(45) Bekanntmachung des Hinweises auf die
Patenterteilung:
09.10.91 Patentblatt 91/41

(84) Benannte Vertragsstaaten:
CH DE FR GB IT LI

(56) Entgegenhaltungen:
EP-A- 0 223 048

(56) Entgegenhaltungen:
CH-A- 627 839
DD-A- 222 790
DE-A- 2 554 473
US-A- 4 666 732

(73) Patentinhaber: Klatt, Helmuth, Dipl.-Ing.
Eichenallee 62
W-1000 Berlin 19 (DE)

(72) Erfinder: Klatt, Helmuth, Dipl.-Ing.
Eichenallee 62
W-1000 Berlin 19 (DE)

(74) Vertreter: Pfenning, Meinig & Partner
Kurfürstendamm 170
W-1000 Berlin 15 (DE)

## Beschreibung

Die Erfindung betrifft ein Verfahren und eine Vorrichtung zum Dosieren und Auftragen von flüssigen oder pastösen Medien auf einen Gegenstand nach dem Oberbegriff des Hauptanspruchs und des nebengeordneten Vorrichtungsanspruchs.

In letzter Zeit hat sich für die Bestückung von Leiterplatten immer mehr SMD-Technik (Service Mounted Device) durchgesetzt. Bei dieser Technik werden die SMD-Bauelemente direkt auf Anschlußflächen auf der Leiterplatte aufgelötet, wobei vor dem Bestücken auf die Anschlußflächen Lötpaste aufgebracht wird. Dies geschieht beispielsweise im Siebdruck über ein Sieb, das das Muster der Anschlußflächen aufweist. Die Lötpaste wird mit einem Rakel auf das Sieb bzw. in die Durchbrüche des Siebes gestrichen und anschließend werden die Bauelemente durch die Lötpaste fixiert. In einem anderen Verfahren werden die Bauelemente mit Kleber an der Leiterplatte befestigt und im Schwallbad gelötet. Die Kleberpunkte werden mit einem Dosiergerät oder Dispenser aufgebracht, das aus einer mit dem Kleber gefüllten Kartusche mit Kanüle und Kolben besteht, der pneumatisch oder hydraulisch betätigt wird. Die Klebermenge wird abhängig vom Druck und von der Zeit gesteuert.

Der Nachteil des Aufbringens der Lötpaste im Siebdruckverfahren liegt darin, daß es sehr aufwendig ist und die Kosten hoch sind. Es müssen größere Serien von Leiterplatten hergestellt werden, die gelagert werden müssen. Die Siebe müssen gesondert gefertigt und nach der Benutzung gereinigt und überprüft werden.

Daher wird nunmehr im Stand der Technik ein Verfahren zum Auftragen der Lötpaste mittels einer Spritze (Dispenser) angewandt, bei dem die Spritze über einen Positioniertisch an die gewünschte Stelle verfahren wird und auf den Kolben der Spritze Druckstöße gegeben werden. Bei bekannten Abmessungen der Kanüle und konstantem Druck kann die Austragmenge über die Zeitdauer der Druckstöße dosiert werden. Es hat sich aber gezeigt, daß diese Dosierung nicht genau genug ist, da bei größer werdendem Luftraum in der Spritze durch Verschieben des Kolbens die Druckstöße gedämpft und somit die Auftragmenge beeinfluß wird.

Der Erfindung liegt daher die Aufgabe zugrunde, ein Verfahren und eine Vorrichtung zum Dosieren und Auftragen von flüssigen oder pastösen Medien auf einen Gegenstand gemäß dem Oberbegriff des Hauptanspruchs zu schaffen, die eine genaue Dosierung der Austragmenge gewährleisten.

Diese Aufgabe wird erfindungsgemäß durch die kennzeichnenden Merkmale des Hauptanspruchs gelöst. Dadurch, daß der Füllstand in dem als Spritze ausgebildeten Dosiergerät erfaßt wird und die Druckbeaufschlagung des Kolbens abhängig vom Füllstand in vorgegebener Weise variiert wird, kann die Austragmenge des Klebers bzw. der Lötpaste genau bestimmt werden. Durch die in den Unteransprüchen angegebenen Maßnahmen sind vorteilhafte Weiterbildungen und Verbesserungen möglich. Besonders vorteilhaft ist, daß die Temperatur des Klebers oder der Lötpaste im Dosiergerät konstant gehalten wird, da dann gleichbleibende Viskositätsverhältnisse bestehen.

Eine besonders einfache und kostengünstige Realisierung des Füllstandsensors liegt in der Verwendung eines kleinen Magneten, der in die Kartusche oder Spritze hinter dem Kolben eingelegt wird und der mit mindestens einem, in unmittelbarer Nähe der Spritze angeordneten Magnetfeldabtaster zusammenarbeiten.

Dadurch, daß die Kanüle des Dosiergerätes schräg zu der Leiterplattenfläche angeordnet ist, kann der Kleber oder die Lötpaste ungehindert aus der Öffnung herausfließen bzw. herausgedrückt werden, ohne daß die Öffnung durch die Leiterplatte selbst verstopft oder behindert wird.

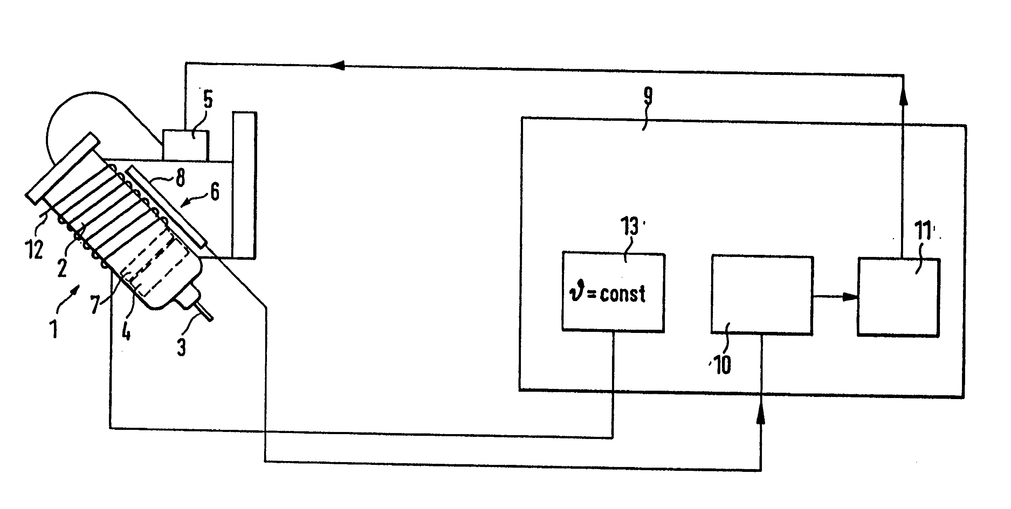

Die Erfindung ist in der Zeichnung dargestellt und wird in der nachfolgenden Beschreibung näher erläutert. Die einzige Figur zeigt eine schematische Darstellung eines Ausführungsbeispiels der Vorrichtung gemäß der Erfindung.

Die in der Figur dargestellte Vorrichtung zum Dosieren und Aufbringen eines Klebers bzw. von Lötpaste auf die Anschlußflächen von Leiterplatten umfaßt ein spritzenförmiges Dosiergerät 1, das als Lötpaste oder den Kleber aufnehmende Kartusche 2 mit daran angesetzter Kanüle 3 ausgebildet ist. In der Kartusche 2 ist ein Kolben 4 angeordent, der vorzugsweise pneumatisch mit Druck beaufschlagt wird. Das Dosiergerät 1 ist über eine Druckleitung mit einem Dosierventil 5 verbunden, das in seiner Offenzeit unter Druck stehende Luft auf den Kolben 4 gibt.

Dem Dosiergerät 1 zugeordnet ist ein Füllstandssensor 6, der aus einem in der Kartusche 2 angeordneten Magneten 7 und einem Magnetfeldabtaster 8, beispielsweise mehreren Spulen, die über die Länge der Kartusche verteilt in ihrer unmittelbaren Nähe angeordnet sind, besteht. Der Abtaster 8 ist über einen nicht dargestellten Signalaufbereitungskreis mit einer Steuer- und Regeleinheit 9 verbunden, der einen Rechner 10 aufweist. In dem Rechner 10 sind die Koordinaten der mit Kleber oder Lötpaste zu versehenden Anschlußflächen gespeichert sowie Informationen über die an den jeweiligen Anschlußflächen aufzubringenden Kleber- bzw. Lötpastenmengen. Aus dem Druck, der auf den Kolben 4 gegeben wird, und der Information über die Austragmenge berechnet der Rechner 10 die Dosierzeit, d.h. den Zeitraum, für den ein Druckstoß auf den Kolben 4 gegeben werden soll.

Weiterhin sind in dem Rechner 10 Korrekturkurven abgelegt, die die Änderung der Dosierzeit für bestimmte Austragmengen abhängig vom Füllstand des Klebers bzw. der Lötpaste in der Kartusche 2 berücksichtigen.

Der Rechner 10 ist mit einem Dosierventiltreiber 11 verbunden, der das Dosierventil 5 elektrisch ansteuert.

Die Kartusche 2 ist in einem Metallmantel, vorzugsweise Aluminium, gelagert und aufgenommen, wobei in dem Mantel eine Heizung 12 in Form einer Heizspirale oder dergleichen eingelassen ist. Die Heizung 12 ist mit einem Heizungsregler 13 verbunden, der die Kartusche 2 auf einer gewünschten konstanten Temperatur hält.

Das Dosiergerät 1 ist in einem Kopf eines Positioniertisches angeordnet und in zumindest drei Achsen (X-, Y-, und Z-Achse) verschiebbar. Das Dosiergerät 1 ist in dem Kopf des Positioniertisches schräg befestigt, d.h., die Kanüle 3 ist schräg zu der Leiterplatte gestellt, so daß die aus der Kanüle 3 austretende Lötpaste ungehindert auf die Anschlußfläche der Leiterplatte gelangt und nicht durch die Leiterplatte selbst behindert wird.

Zum Ausbringen von Lötpaste auf vorbestimmte Anschlußflächen wird der Positioniertisch in die gewünschte X-Y-Stellung der Anschlußfläche auf der Leiterplatte gefahren, wobei er von dem Rechner 10 gesteuert wird. In einer anderen Ausführungsform kann das Dosiergerät feststehen und die Leiterplatte verfahren werden. Der Kopf des Positioniertisches mit dem Dosiergerät wird über ein nicht dargestelltes Ventil abgesenkt, so daß sich die Öffnung der Kanüle 3 schräg über der Anschlußfläche der Leiterplatte befindet. Das Magnetfeld des Magnets 7 über dem Kolben 4 in der Kartusche 2 wird von dem Magnetfeldabtaster 8 erfaßt und aus seinen Ausgangssignalen kann der Füllstand der Lötpaste in der Kartusche 2 bestimmt werden.

Der Rechner berechnet, abhängig vom Füllstand der Kartusche und der gewünschten Ausbringmenge an Lötpaste und über den Druck, der konstant gehalten wird, die Dosierzeit, d.h. die Dauer, für die ein Druckstoß auf den Kolben gegeben wird. Da die Temperatur der Lötpaste auf einem konstanten Wert gehalten wird, muß ihre Viskosität nicht mit berücksichtigt werden. Die Dosierzeit liegt zwischen 20 ms und 500 ms. Über den Dosierventiltreiber 11 wird das Dosierventil 5 angesteuert, das für die berechnete Dosierzeit öffnet und einen Druckstoß auf den Magneten 7 und den Kolben 4 leitet. Durch diesen Druckstoß bewegt sich der Kolben 4 und der Magnet 7 und Lötpaste wird durch die Kanüle 3 auf die Anschlußfläche der Leiterplatte gedrückt. Anschließend fährt der Kopf des Positioniertisches mit dem Dosiergerät nach oben und die Kartusche wird entlüftet. Dieser Vorgang wird bei jeder Anschlußfläche wiederholt. Dabei ist es nicht nötig, daß der Füllstand bei jedem Dosiervorgang abgefragt wird, da die Stellung des Kolbens bzw. des Magneten 7 sich jeweils nur geringfügig ändert.

Das oben beschriebene Ausführungsbeispiel ist eine bevorzugte Ausführungsform, selbstverständlich sind andere Realisierungen möglich. Als Füllstandssensoren können beliebige Wegsensoren, beispielsweise kapazitiver oder optischer Art, verwendet werden. Auch Potentiometer mit über die Länge der Kartusche sich ändernden Widerstand oder Differentialübertrager sind möglich. In dem Ausführungsbeispiel nach der Figur wird die Lötpaste über eine Heizung 12 auf einer konstanten Temperatur gehalten. Es ist aber auch denkbar, daß die Temperatur mittels eine Kühlung, beispielsweise über ein Peltier-Element, konstant gehalten wird. Es ist aber auch möglich, daß die Temperatur der Lötpaste bestimmt wird und die sich aufgrund von unterschiedlichen Temperaturen ändernde Viskosität von dem Rechner bei der Berechnung der Dosierzeit berücksichtigt wird. Weiterhin ist es möglich, nicht die Zeitdauer der Druckstöße abhängig von dem Füllstand zu verändern, sondern die Stärke der Druckstöße, beispielsweise über ein Servoventil.

In dem Ausführungsbeispiel ist die Erfindung als Verfahren und Vorrichtung zum Aufbringen der Lötpaste in der SMD-Technik beschrieben. Es sind aber Anwendungen unterschiedlichster Art möglich, beispielsweise kann Lötpaste auf beliebig zu kontaktierende und zu verzinnende Materialien aufgebracht werden. Weiterhin kann die Erfindung dort eingesetzt werden, wo Bauelemente, wie Schrauben mit Kleber oder dergleichen, gesichert, Gehäuse verklebt oder andere mechanische Verbindungen hergestellt werden müssen. Auch in der Automobilindustrie wird immer mehr die Klebetechnik angewandt, beispielsweise zum Einkleben von Lagern und Buchsen, wobei die Klebstoffe genau dosiert und aufgebracht werden müssen. Ein weiteres Anwendungsgebiet ist das Dosieren und Aufbringen von Abdecklacken in der Elektroindustrie oder von Lacken oder Farbstoffen für Markierungen auf elektrischen und elektronischen Bauelementen.

## Patentansprüche

1. Verfahren zum Dosieren und Auftragen von flüssigen oder pastösen Medien auf einen Gegenstand, bei dem ein mit dem Medium gefülltes Dosiergerät jeweils relativ zu dem Gegenstand positioniert und mit Druck beaufschlagt wird, wobei über eine Steuer-und Regeleinheit die Druckbeaufschlagung derart gesteuert wird, daß vorwählbare Dosierungen der Medien geliefert werden, **dadurch gekennzeichnet, daß** der Füllstand des Medium in dem Dosiergerät erfaßt wird und die Druckbeaufschlagung abhängig vom Füllstand in vorgegebener Weise verändert wird.

2. Verfahren nach Anspruch 1, dadurch gekennzeichnet, daß die Temperatur des Medium im Dosiergerät konstant gehalten wird.

3. Verfahren nach Anspruch 2, dadurch gekennzeichnet, daß das Dosiergerät beheizt oder gekühlt wird.

4. Verfahren nach Anspruch 1, dadurch gekennzeichnet, daß bei konstantem Druck die Zeitdauer der Druckbeaufschlagung abhängig vom Füllstand variiert wird.

5. Verfahren nach Anspruch 1, dadurch gekennzeichnet, daß die Stärke der Druckbeaufschlagung abhängig vom Füllstand variiert wird.

6. Vorrichtung zum Dosieren und Auftragen von flüssigen oder pastösen Medien auf einen Gegenstand, mit einem mit dem Medium gefüllten Dosiergerät, einer das Dosiergerät relativ zum Gegenstand verfahrbaren Positioniereinheit und einer Steuer- und Regeleinheit, die das Dosiergerät abhängig von der gewünschten Ausbringmenge des Medium mit Druck beaufschlagt, dadurch gekennzeichnet, daß ein den Füllstand des Medium im Dosiergerät (1) messender Füllstandssensor (7,8) vorgesehen ist, der mit der Steuer- und Regeleinheit (9) verbunden ist, wobei die Steuer- und Regeleinheit (9) vom Füllstand abhängige Steuersignale liefert, die ein pneumatisches oder hydraulisches, mit der Steuer- und Regeleinheit (9) elektrisch verbundenes Dosierventil (5) ansteuern.

7. Vorrichtung nach Anspruch 6, dadurch gekennzeichnet, daß das Dosiergerät (1) eine Heizung (12) oder Kühlung aufweist, die mit einem Temperaturregler (13) verbunden ist.

8. Vorrichtung nach Anspruch 6 oder 7, dadurch gekennzeichnet, daß die Offenzeit des Dosierventils (5) abhängig von den Steuersignalen veränderbar ist.

9. Vorrichtung nach Anspruch 6 oder 7, dadurch gekennzeichnet, daß das Dosierventil als Servoventil ausgebildet ist, das abhängig von den Steuersignalen Druckstöße veränderlicher Stärke liefert.

10. Vorrichtung nach Anspruch 6 oder 7, dadurch gekennzeichnet, daß das Dosiergerät (1) als Kartusche (2) mit durch Druck verschiebbarem Kolben (4) ausgebildet ist.

11. Vorrichtung nach einem der Ansprüche 6 bis 9, dadurch gekennzeichnet, daß der Füllstandssensor (7,8) aus einem in dem Dosiergerät (1) verschiebbar angeordneten Magneten (7) und mindestens einem das Magnetfeld erfassenden Abtaster (8) besteht.

12. Vorrichtung nach Anspruch 10 oder 11, dadurch gekennzeichnet, daß der das Magnetfeld erfassende Abtaster als Spule ausgebildet ist, und daß über die Länge des Dosiergerätes (1) mehrere Spulen (8) angeordnet sind.

13. Vorrichtung nach einem der Ansprüche 6 bis 12, dadurch gekennzeichnet, daß das Dosiergerät (1) eine Kanüle (3) aufweist, die beim Ausbringen des Medium eine schräge Stellung zu dem Gegenstand aufweist.

14. Vorrichtung nach einem der Ansprüche 6 bis 13, dadurch gekennzeichnet, daß die Steuer- und Regeleinheit (9) einen Rechner (10) mit Speicher aufweist, der vom Füllstand des Medium im Dosiergerät (1) abhängige Korrekturkurven speichert.

## Claims

1. Method for metering and applying liquid or pasty media on an object in which a metering device filled with the medium is positioned in each case relative to the object and impacted with pressure, the pressure impaction being controlled in such a way via a control and regulating unit that preselectable dosages of the media are delivered, characterized in that the filling level of the medium in the metering device is detected and the pressure impaction changed in a predefined way depending on the filling level.

2. Method according to Claim 1, characterized in that the temperature of the medium in the metering device is kept constant.

3. Method according to Claim 2, characterized in that the metering device is heated or cooled.

4. Method according to Claim 1, characterized in that at a constant pressure the period of pressure impaction is varied depending on the filling level.

5. Method according to Claim 1, characterized in that the strength of the pressure impaction is varied depending on the filling level.

6. Device for metering and applying liquid or pasty media on an object, with a metering device filled with the medium, a positioning unit which can move the metering device relative to the object and a control and regulating unit which impacts the metering device with pressure depending on the desired output quantity of the medium, characterized in that a level sensor (7, 8) measuring the level of the medium in the metering device (1) is provided which is connected to the control and regulating unit (9), the control and regulating unit (9) supplying control signals dependent on the level, which drive a pneumatic or hydraulic metering device (5) electrically connected to the control and regulating unit (9).

7. Device according to Claim 6, characterized in that the metering device (1) has a heater (12) or cooler which is connected to a temperature regulator (13).

8. Device according to Claim 6 or 7, characterized in that the open time of the metering valve (5) is alterable depending on the control signals.

9. Device according to Claim 6 or 7, characterized in that the metering valve is formed as a servo valve which supplies pressure thrusts depending on the control signals.

10. Device according to Claim 6 or 7, characterized in that the metering device (1) is formed as a cartridge (2) with a piston (4) sliding by pressure.

11. Device according to one of Claims 6 to 9, characterized in that the level sensor (7, 8) consists of a magnet (7) arranged to slide in the metering device (1) and at least one scanner (8) detecting the magnetic field.

12. Device according to Claim 10 or 11, characterized in that the scanner detecting the magnetic field is formed as a coil, and that several coils (8) are arranged over the length of the metering device (1).

13. Device according to one of Claims 6 to 12, characterized in that the metering device (1) exhibits a cannula (3) which when the medium is brought out shows a skew position in relation to the object.

14. Device according to one of Claims 6 to 13, characterized in that the control and regulating unit (9) exhibits a computer (10) with memory, which stores correction curves dependent on the level of the medium in the metering device (1).


## Revendications

1. Dispositif pour doser et appliquer des milieux liquides ou pâteux sur un objet, dans lequel un appareil de dosage renfermant le milieu est chaque fois positionné par rapport à l'objet et alimenté en pression, l'application de la pression étant actionnée par une unité de commande et de réglage de telle manière que des doses prédéterminées de milieu soient fournies, caractérisé en ce que le niveau du milieu dans l'appareil de dosage est détecté et que l'application de la pression est modifiée de manière prédéfinie en fonction du niveau.

2. Procédé selon la revendication 1, caractérisé en ce que la température du milieu est maintenue constante dans l'appareil de dosage.

3. Procédé selon la revendication 2, caractérisé en ce que l'appareil de dosage est chauffé ou refroidi.

4. Procédé selon la revendication 1, caractérisé en ce que, pour une pression constante, la durée de l'application de la pression est modulable en fonction du niveau.

5. Procédé selon la revendication 1, caractérisé en ce que l'intensité de la pression appliquée est modulable en fonction du niveau.

6. Dispositif pour doser et appliquer des milieux liquides ou pâteux sur un objet au moyen d'un appareil de dosage, d'une unité de positionnement pour déplacer l'appareil de dosage par rapport à l'objet et d'une unité de commande et de réglage, qui alimente en pression l'appareil de dosage en fonction du débit de milieu souhaité, caractérisé en ce qu'un détecteur de niveau (7, 8) mesurant le niveau du milieu dans l'appareil de dosage (1) est prévu et en ce qu'il est relié à l'unité de commande et de réglage (9), qui fournit des signaux de commande dépendant du niveau, ces signaux commandant une soupape de dosage (5) pneumatique ou hydraulique, reliée électriquement à l'unité de commande et de réglage (9).

7. Dispositif selon la revendication 6, caractérisé en ce que l'appareil de dosage (1) comporte un chauffage (12) ou un refroidissement, qui est relié à un thermostat (13).

8. Dispositif selon la revendication 6 ou 7, caractérisé en ce que le temps d'ouverture de la soupape de dosage (5) peut être modifié en fonction des signaux de commande.

9. Dispositif selon la revendication 6 ou 7, caractérisé en ce que la soupape de dosage est conçue sous forme de servovalve qui fournit des pressions d'intensité réglable, en fonction des signaux de commande.

10. Dispositif selon la revendication 6 ou 7, caractérisé en ce que l'appareil de dosage (1) est conçu sous forme d'une cartouche (2) avec un piston (4) à déplacement commandé par la pression.

11. Dispositif selon l'une quelconque des revendications 6 à 9, caractérisé en ce que le détecteur de niveau (7, 8) se compose d'un aimant (7) logé de manière mobile dans l'appareil de dosage (1) et d'au moins un palpeur (8) détectant le champ magnétique.

12. Dispositif selon la revendication 10 ou 11, caractérisé en ce que le palpeur détectant le champ magnétique est conçu sous la forme d'une bobine, et en ce que plusieurs bobines (8) sont disposées sur la longueur de l'appareil de dosage (1).

13. Dispositif selon l'une quelconque des revendications 6 à 12, caractérisé en ce que l'appareil de dosage (1) comporte une canule (3), qui a une position oblique par rapport à l'objet lors du déversement de milieu.

14. Dispositif selon l'une quelconque des revendications 6 à 13, caractérisé en ce que l'unité de commande et de réglage (9) comporte un appareil à mémoire (10) qui mémorise des courbes d'erreur dépendant au niveau du milieu dans l'appareil de dosage (1).